# EUROPEAN PATENT APPLICATION

(11) **EP 4 811 039 A2**
(43) Date of publication of application: **23.09.2026**
(21) Application number: 26196253.4
(22) Date of filing: 02.02.2024
(51) Int. Cl.: G03F 7/095

(54) **COMPOSITION FOR FORMING RESIST UNDERLAYER FILM TO REDUCE ENVIRONMENTAL IMPACT**

(30) Priority: 03.02.2023 JP 2023015575
(62) Document number(s) of the earlier application(s) in accordance with Art. 76 EPC: 24750408.7 / 4 641 300
(71) Applicant: Nissan Chemical Corporation, Tokyo 103-6119 (JP)
(72) Inventor: KAMIBAYASHI, Satoshi, Toyama-shi, Toyama 939-2792 (JP); KISHIOKA, Takahiro, Toyama-shi, Toyama 939-2792 (JP)
(74) Representative: Müller-Boré & Partner Patentanwälte PartG mbB

(57) **Abstract**

A resist underlayer film-forming composition containing
a first component, a second component, and a solvent, in which
the first component has an aromatic ring and at least one oxygen atom directly bonded to the aromatic ring by a single bond,
the second component is a water-soluble polymer,
a mass ratio between the first component and the second component (first component:second component) is 99:1 to 50:50,
the solvent contains water in an amount of 50 mass% or more based on the solvent, and
the resist underlayer film-forming composition contains a curing catalyst.

## Description

### Technical Field

The present invention relates to a resist underlayer film-forming composition, a resist underlayer film, a semiconductor processing substrate, a method for manufacturing a semiconductor element, and a method for forming a pattern.

### Background Art

In manufacture of a semiconductor device, micromachining by lithography has been conventionally performed using a photoresist composition. The micromachining is a processing method in which a thin film of a photoresist composition is formed on a silicon wafer, irradiated with an active energy ray such as an ultraviolet ray through a mask pattern on which a pattern of a semiconductor device is drawn, and developed and the silicon wafer is etched using the obtained resist pattern as a protective film.

However, in recent years, as the degree of integration of semiconductor devices has increased, the influence of diffuse reflection of active energy rays from a substrate and standing waves has been a major problem. Then, a method for providing a bottom anti-reflective coating (BARC), which is a resist underlayer film, between a photoresist and a substrate has been widely studied.

For example, the present applicant has proposed an antireflection film forming composition which has a high antireflection light effect, does not cause intermixing with a resist layer, can obtain an excellent resist pattern and a wide focus depth margin, and can obtain an antireflection film for lithography having a higher dry etching rate than a resist (refer to Patent Literature 1).

### Citation List

### Patent Literature

Patent Literature 1: WO2003/017002

### Summary of Invention

### Technical Problem

The resist underlayer film-forming composition is generally an organic solvent-based composition prepared by dissolution of a polymer in an organic solvent.

Replacement of organic solvent-based paints with aqueous paints has been actively studied from the viewpoints of the influence of volatile organic solvents on the environment, the health of operators who handle paints, and the like.

The resist underlayer film-forming composition is used in a clean room. Accordingly, volatile organic solvents are hardly released into the environment, and operators are not exposed to the organic solvents.

However, an aqueous composition is preferable from the viewpoint of treatment of waste liquid and the viewpoint that the organic solvent-based composition is combustible and care is required for handling and transportation.

An object of the present invention is to provide a resist underlayer film-forming composition using water as a solvent, a resist underlayer film, a semiconductor processing substrate, a method for manufacturing a semiconductor element, and a method for forming a pattern.

### Solution to Problem

As a result of intensive studies to solve the above problem, the present inventors have found that the above problem can be solved, and have completed the present invention having the following gist.

That is, the present invention includes the following aspects.
[1] A resist underlayer film-forming composition containing
   a first component and a solvent, in which
   the first component has an aromatic ring, at least one oxygen atom directly bonded to the aromatic ring by a single bond, and at least one hydroxy group other than a phenolic hydroxy group, and
   the solvent contains water in an amount of 50 mass% or more based on the solvent.
[2] A resist underlayer film-forming composition containing
   a first component, a second component, and a solvent, in which
   the first component has an aromatic ring and at least one oxygen atom directly bonded to the aromatic ring by a single bond,
   the second component is a water-soluble polymer,
   a mass ratio between the first component and the second component (first component:second component) is 99:1 to 50:50, and
   the solvent contains water in an amount of 50 mass% or more based on the solvent.
[3] The resist underlayer film-forming composition according to [1], further containing a second component that is a water-soluble polymer.
[4] The resist underlayer film-forming composition according to [3], in which a mass ratio between the first component and the second component (first component:second component) is 99:1 to 50:50.
[5] The resist underlayer film-forming composition according to [1], in which the first component has an aromatic ring, at least two oxygen atoms directly bonded to the aromatic ring by a single bond, and at least one hydroxy group other than a phenolic hydroxy group.
[6] The resist underlayer film-forming composition according to [2], in which the first component has an aromatic ring and at least two oxygen atoms directly bonded to the aromatic ring by a single bond.
[7] The resist underlayer film-forming composition according to any one of [1] to [3], in which the first component has at least one of a flavone structure and a flavanone structure.
[8] The resist underlayer film-forming composition according to any one of [1] to [4], in which the first component has a quercetin structure.
[9] The resist underlayer film-forming composition according to [8], in which the first component is at least one selected from
   α-glucosylrutin,
   troxerutin, and
   a reaction product of at least one of quercetin and a quercetin glycoside with an epoxy group-containing compound.
[10] The resist underlayer film-forming composition according to [9], in which the epoxy group-containing compound is an aliphatic epoxy compound having at least one epoxy group.
[11] The resist underlayer film-forming composition according to [2] or [3], in which the water-soluble polymer is at least one selected from polyvinyl alcohol, polyvinylpyrrolidone, polystyrenesulfonic acid, and water-soluble cellulose.
[12] The resist underlayer film-forming composition according to any one of [1] to [11], further including a crosslinking agent.
[13] The resist underlayer film-forming composition according to any one of [1] to [12], further including a curing catalyst.
[14] A resist underlayer film, which is a cured product of the resist underlayer film-forming composition according to any one of [1] to [13].
[15] A semiconductor processing substrate including:
   a semiconductor substrate; and
   the resist underlayer film according to [14].
[16] A method for manufacturing a semiconductor element, the method including:
   a step of forming a resist underlayer film on a semiconductor substrate using the resist underlayer film-forming composition described in any one of [1] to [13]; and
   a step of forming a resist film on the resist underlayer film.
[17] A method for forming a pattern including:
   a step of forming a resist underlayer film on a semiconductor substrate using the resist underlayer film-forming composition according to any one of [1] to [13];
   a step of forming a resist film on the resist underlayer film;
   a step of irradiating the resist film with light or an electron beam, and then developing the resist film to obtain a resist pattern; and
   a step of etching the resist underlayer film using the resist pattern as a mask.

### Advantageous Effects of Invention

According to the present invention, it is possible to provide a resist underlayer film-forming composition using water as a solvent, a resist underlayer film, a semiconductor processing substrate, a method for manufacturing a semiconductor element, and a method for forming a pattern. The amount of the organic solvent used in this field in the related art can be reduced, and this can contribute to reduction in environmental load.

### Description of Embodiments

### (Resist Underlayer Film-Forming Composition)

An embodiment of a resist underlayer film-forming composition of the present invention contains a first component and water.

An embodiment of the resist underlayer film-forming composition of the present invention contains a first component, a second component, and water.

### <First Component>

The first component is an organic compound.

The first component is, for example, a component that may be used in combination with the second component, in the resist underlayer film-forming composition. The first component is an organic compound that is dissolved in the solvent in order to be used as the resist underlayer film-forming composition.

The molecular weight of the first component is not particularly limited, and the first component may be a low molecular compound or a high molecular compound.

The organic compound as the first component has, for example, an aromatic ring and at least one oxygen atom directly bonded to the aromatic ring by a single bond.

The organic compound as the first component has, for example, an aromatic ring and at least two oxygen atoms directly bonded to the aromatic ring by a single bond.

The organic compound as the first component has, for example, an aromatic ring, at least one oxygen atom directly bonded to the aromatic ring by a single bond, and at least one hydroxy group other than a phenolic hydroxy group.

The organic compound as the first component has, for example, an aromatic ring, at least two oxygen atoms directly bonded to the aromatic ring by a single bond, and at least one hydroxy group other than a phenolic hydroxy group.

The organic compound as the first component has, for example, an aromatic ring, at least two oxygen atoms directly bonded to the aromatic ring by a single bond, and at least two hydroxy groups other than a phenolic hydroxy group.

When the first component has an aromatic ring, excellent solvent resistance and excellent antireflection performance are imparted to the resist underlayer film obtained from the resist underlayer film-forming composition.

The organic compound as the first component may or may not have a phenolic hydroxy group.

Examples of the hydroxy group other than the phenolic hydroxy group include a hydroxy group bonded to a carbon atom that does not constitute an aromatic ring. Examples of such a hydroxy group include a hydroxy group generated by a ring-opening reaction of an epoxy group, and a hydroxy group of a sugar.

The organic compound as the first component preferably has at least one of a flavone structure and a flavanone structure, more preferably has a flavonol structure, and particularly preferably has a quercetin structure, in that the organic compound is excellent in absorbance of i-line (365 nm).

Here, the flavone structure means a flavone itself represented by Formula (f-1) described below and a structure in which at least one hydrogen atom of the flavone is substituted.

The flavanone structure means flavanone itself represented by the Formula (f-2) described below and a structure in which at least one hydrogen atom of flavanone is substituted.

The flavonol structure means a flavonol itself represented by Formula (f-3) described below and a structure in which at least one hydrogen atom of the flavonol is substituted.

The quercetin structure means quercetin itself represented by Formula (q) described below and a structure in which at least one hydrogen atom of quercetin is substituted.

The quercetin structure is an example of a flavonol structure. The flavonol structure is an example of a flavone structure. Therefore, when a compound has a quercetin structure, the compound has a flavonol structure. In addition, the compound has a flavone structure.

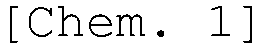

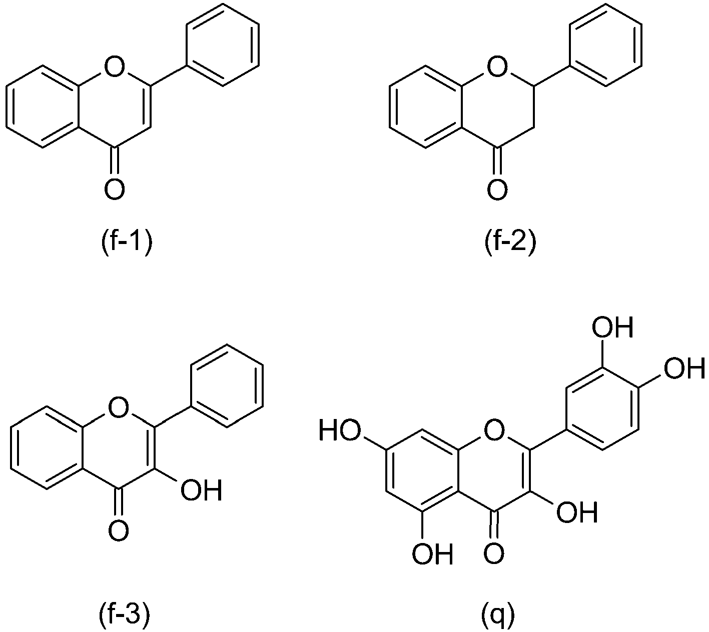

Here, in the present invention, the aromatic ring may be a single ring or a condensed ring. The aromatic ring may be an aromatic hydrocarbon ring or may be an aromatic heterocyclic ring.

Examples of the aromatic hydrocarbon ring include a benzene ring, a naphthalene ring, an acenaphthylene ring, a phenanthrene ring, an anthracene ring, and a pyrene ring.

Examples of the aromatic heterocyclic ring include a thiophene ring, a pyrrole ring, an imidazole ring, an oxazole ring, a thiazole ring, a pyridine ring, a pyridazine ring, a pyrimidine ring, a pyrazine ring, a quinoline ring, an indole ring, an indazole ring, a benzotriazole ring, a quinazoline ring, an acridine ring, a chromanone ring, and a chromone ring.

The benzene ring and the chromone ring in the flavone structure, the flavonol structure, and the quercetin structure are each an aromatic ring in the present invention.

The benzene ring and the chromanone ring in the flavanone structure are each an aromatic ring in the present invention.

In the present invention, the oxygen atom of the -OH group in the flavonol and quercetin is an oxygen atom directly bonded to the aromatic ring by a single bond. When the hydrogen atom of the -OH group in the flavonol and quercetin is substituted, the oxygen atom is bonded to an atom other than the atom constituting the aromatic ring by another single bond.

The organic compound as the first component is preferably a compound having at least one of a flavone structure and a flavanone structure.

The organic compound as the first component is preferably a reaction product of a compound having at least one of a flavone structure and a flavanone structure with an epoxy group-containing compound.

Examples of the compound having a flavone structure include flavones and flavonols.

Examples of flavonols which are compounds having a flavone structure include quercetin and quercetin derivatives.

Examples of the quercetin derivative include quercetin glycosides.

Examples of such quercetin glycosides include quercitrin, isoquercitrin, hyperoside, rutin, troxerutin, and α-glucosylrutin.

These may be hydrates.

For reference, the structures of quercetin hydrate, quercitrin, isoquercitrin, hyperoside, rutin hydrate, troxerutin, and α-glucosylrutin are shown below.
Quercetin hydrate
Quercitrin 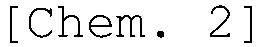 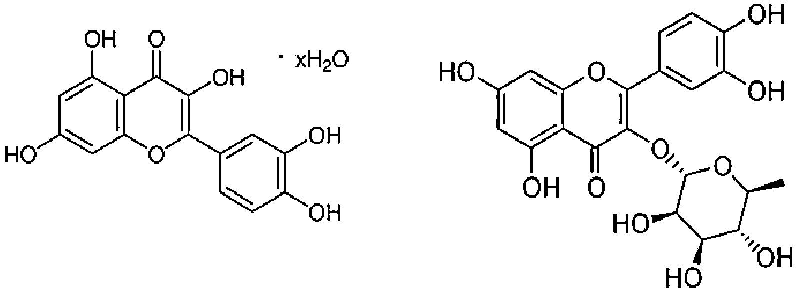
· Isoquercitrin
· Hyperoside 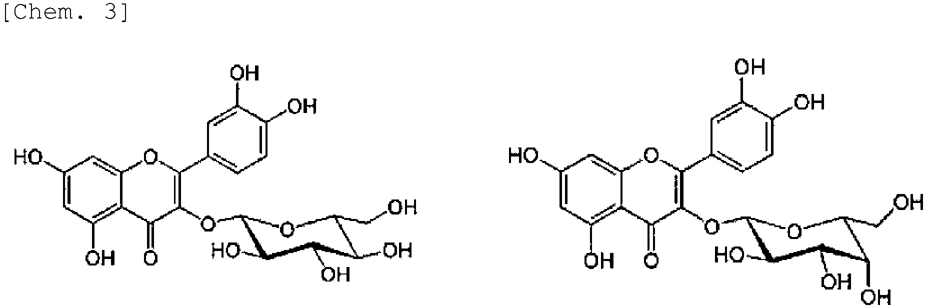
· Rutin hydrate
· troxerutin 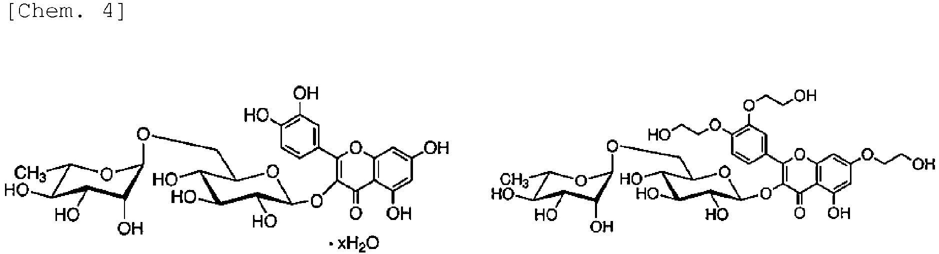
· α-glucosylrutin

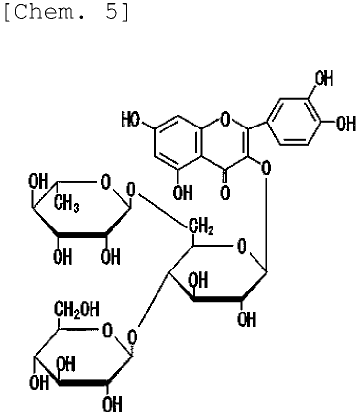

Examples of the compound having a flavanone structure include hesperetin and hesperetin derivatives.

Examples of the hesperetin derivative include hesperetin glycosides.

Examples of such a hesperetin glycoside include hesperidin and methyl hesperidin.

These may be hydrates.

For reference, structures of hesperetin, hesperidin, and methyl hesperidin are shown below.
· Hesperetin 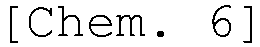 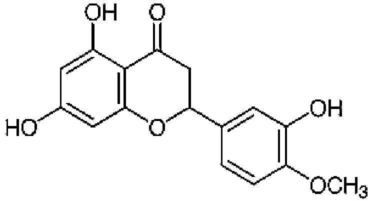
· Hesperidin
· Methyl hesperidine

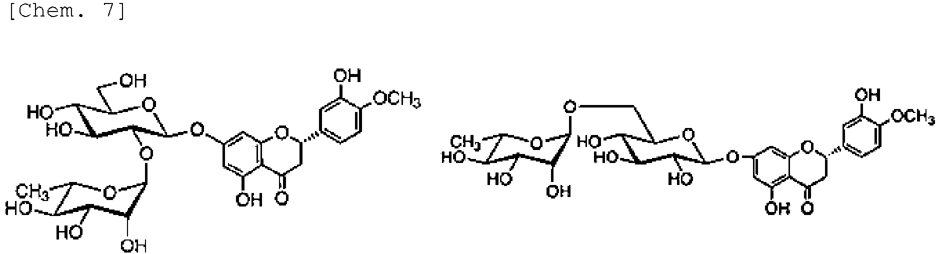

Other examples of the compound having a flavanone structure include naringenin and naringenin derivatives.

Examples of the naringenin derivative include naringenin glycosides.

Examples of such a naringenin glycoside include naringin.

These may be hydrates.

For reference, the structures of naringenin and naringin hydrate are shown below.
· Henaringenin
· Naringin hydrate

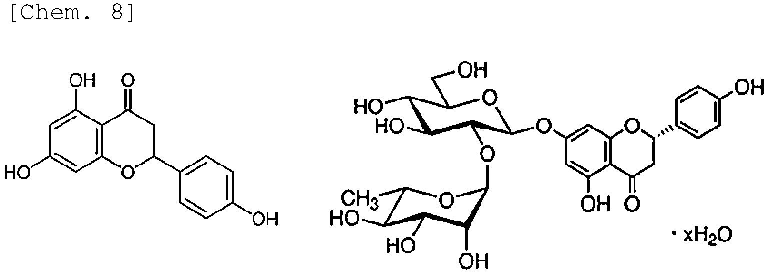

Other examples of the compound having a flavone structure include, for example, chrysin, baicalein, galangin, apigenin, wogonin, acacetin, luteolin, kaempferol, scutellarin, diosmetin, kaempferide, morin, isorhamnetin, myricetin, tetramethylscutellarein, eupatilin, icaritin, tangeretin, nobiletin, and the like. These may be hydrates.

For reference, these structures are shown below.
Chrysin
Baicalein
Galangin
Apigenin 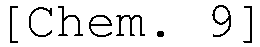 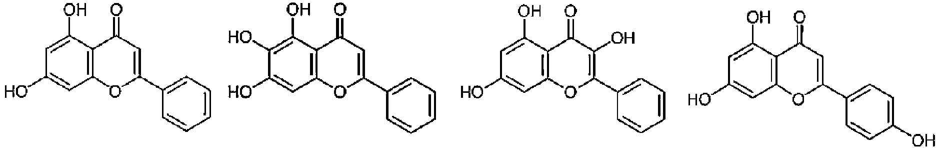
· Wogonin
· Acacetin
· Luteolin
· Kaempferol hydrate 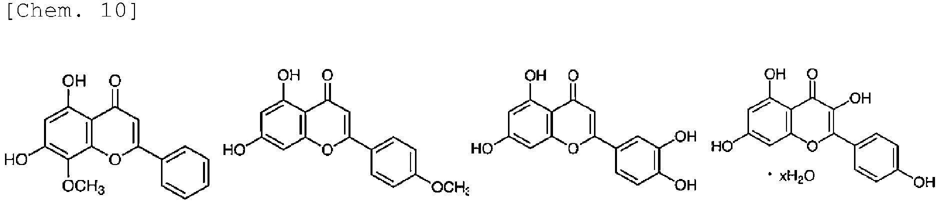
· Scutellarein
· Diosmetin
· Kaempferide
· Morin hydrate 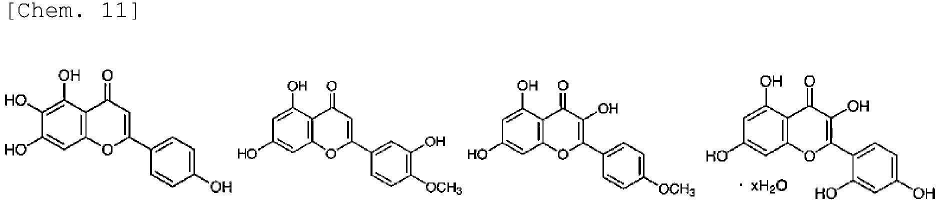
· Isorhamnetin
· Myricetin
· Scutellarein tetramethyl ether
· Eupatilin 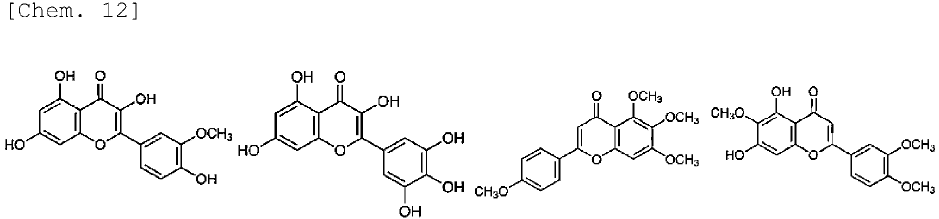
· Icaritin
· Tangeretin
· Nobiletin

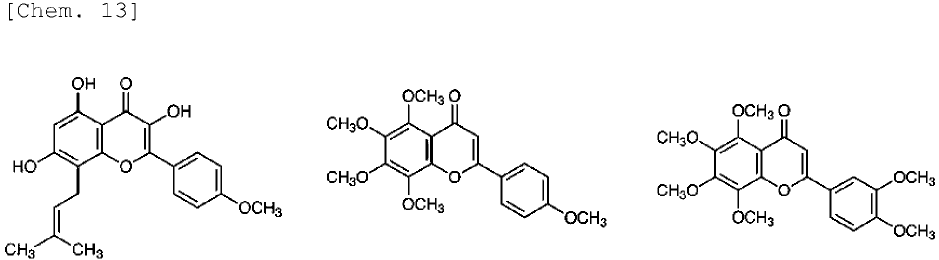

The epoxy group-containing compound for obtaining the reaction product is not particularly limited as long as the epoxy group-containing compound is a compound having at least one epoxy group.

The number of epoxy groups in the epoxy group-containing compound is, for example, 1 to 4, and preferably 1 or 2.

Examples of the epoxy group-containing compound include aliphatic epoxy compounds and aromatic epoxy compounds. Among them, an aliphatic epoxy compound is preferable from the viewpoint of solubility in water.

Examples of the aliphatic epoxy compound include glycidol, a glycidyl etherified product of an aliphatic alcohol, and a polyglycidyl etherified product of an aliphatic polyhydric alcohol or an alkylene oxide adduct thereof.

Specific examples of the aliphatic epoxy compound include glycidol, allyl glycidyl ether, butyl glycidyl ether, 2-ethylhexyl glycidyl ether, C12-C13 mixed alkyl glycidyl ether; glycidyl ether of polyalcohol such as 1,4-butanediol diglycidyl ether, 1,6-hexanediol diglycidyl ether, triglycidyl ether of glycerin, triglycidyl ether of trimethylolpropane, tetraglycidyl ether of sorbitol, hexaglycidyl ether of dipentaerythritol, diglycidyl ether of polyethylene glycol, diglycidyl ether of polypropylene glycol, diglycidyl ether of neopentyl glycol; a polyglycidyl etherified product of polyether polyols obtained by adding one or more alkylene oxides to aliphatic polyhydric alcohols such as propylene glycol, trimethylolpropane, and glycerin; monoglycidyl ethers of aliphatic higher alcohols; and epoxidized polybutadiene.

In addition, examples thereof also include compounds having a tricyclodecane structure and a glycidyl ether group, such as dimethylol tricyclodecane diglycidyl ether and tricyclodecane diglycidyl ether.

In addition, a compound obtained by reacting an aliphatic glycidyl ether type epoxy compound having two or more glycidyl ether groups with a main chain skeleton containing a rubber component and containing a group capable of forming a covalent bond by reacting with an epoxy group can also be mentioned.

As the aliphatic epoxy compound, commercially available products can be used, and examples thereof include Denacol EX-121, Denacol EX-171, Denacol EX-192, Denacol EX-211, Denacol EX-212, Denacol EX-252, Denacol EX-313, Denacol EX-314, Denacol EX-321, Denacol EX-411, Denacol EX-421, Denacol EX-512, Denacol EX-521, Denacol EX-611, Denacol EX-612, Denacol EX-614, Denacol EX-622, Denacol EX-810, Denacol EX-811, Denacol EX-850, Denacol EX-851, Denacol EX-821, Denacol EX-830, Denacol EX-832, Denacol EX-841, Denacol EX-861, Denacol EX-911, Denacol EX-941, Denacol EX-920, Denacol EX-931 (manufactured by Nagase ChemteX Corporation); Epolite M-1230, Epolite 40E, Epolite 100E, Epolite 200E, Epolite 400E, Epolite 70P, Epolite 200P, Epolite 400P, Epolite 1500NP, Epolite 1600, Epolite 80MF, and Epolite 100MF (manufactured by Kyoeisha Chemical Co., Ltd.); and Adeka Glycerol ED-503, Adeka Glycerol ED-503G, Adeka Glycerol ED-506, and Adeka Glycerol ED-523T (manufactured by ADEKA Corporation).

The epoxy group in the aliphatic epoxy compound may be an alicyclic epoxy group. The aliphatic epoxy compound (hereinafter may be referred to as an "alicyclic epoxy compound") when the epoxy group is an alicyclic epoxy group is not particularly limited.

The alicyclic epoxy compound is a compound having a cycloalkene oxide structure and having no aromatic ring.

The cycloalkene oxide structure is a structure in which an aliphatic ring and an epoxy ring share a part of a ring structure, like a cyclohexene oxide structure or a cyclopentene oxide structure obtained by epoxidizing a cyclohexene ring-containing compound or a cyclopentene ring-containing compound with an oxidizing agent.

The alicyclic epoxy compound may have an epoxy group having a cycloalkene oxide structure. Therefore, a compound having a cycloalkene oxide structure and an epoxy group that does not share a part of a ring structure with an aliphatic ring, such as diglycidyl 4,5-epoxycyclohexane-1,2-dicarboxylate, also corresponds to the alicyclic epoxy compound.

Examples of the cycloalkene oxide structure of the alicyclic epoxy compound include a cyclopentene oxide structure (5-membered ring) and cyclohexene oxide (6-membered ring) depending on the number of carbon atoms constituting the cycloalkene.

Examples of the alicyclic epoxy compound include 3,4-epoxycyclohexylmethyl-3,4-epoxycyclohexanecarboxylate, 3,4-epoxy-1-methylcyclohexyl-3,4-epoxy-1-methylhexanecarboxylate, 6-methyl-3,4-epoxycyclohexylmethyl-6-methyl-3,4-epoxycyclohexanecarboxylate, 3,4-epoxy-3-methylcyclohexylmethyl-3,4-epoxy-3-methylcyclohexanecarboxylate, 3,4-epoxy-5-methylcyclohexylmethyl-3,4-epoxy-5-methylcyclohexanecarboxylate, 2-(3,4-epoxycyclohexyl-5,5-spiro-3,4-epoxy)cyclohexane-metadioxane, bis(3,4-epoxycyclohexylmethyl) adipate, methylenebis(3,4-epoxycyclohexane), propan-2,2-diyl-bis(3,4-epoxycyclohexane), 2,2-bis(3,4-epoxycyclohexyl)propane, dicyclopentadiene diepoxide, ethylene bis(3,4-epoxycyclohexanecarboxylate), dioctyl epoxyhexahydrophthalate, di-2-ethylhexyl epoxyhexahydrophthalate, 1-epoxyethyl-3,4-epoxycyclohexane, 1,2-epoxy-2-epoxyethylcyclohexane, α-pinene oxide, and ε-caprolactone-modified 3',4'-epoxycyclohexylmethyl 3,4-epoxycyclohexanecarboxylate.

As the alicyclic epoxy compound, commercially available products can be used, and examples thereof include: UVR6105, UVR6110, and UVR6128 (manufactured by Union Carbide Corporation); Ceroxide 2021P, Ceroxide 2081, Ceroxide 2083, Ceroxide 2085, Ceroxide 2000, Ceroxide 3000, Cyclomer A200, Cyclomer M100, Cyclomer M101, Epolead GT-301, Epolead GT-302, Epolead GT-401, Epolead GT-403, ETHB, and Epolead HD300 (manufactured by Daicel Corporation); and THI-DE, DE-102, and DE-103 (manufactured by JXTG Nippon Oil & Energy Corporation).

Examples of aromatic epoxy compounds include:
polyglycidyl etherified products of polyhydric phenols having at least one aromatic ring, such as bisphenol A or bisphenol F, or their alkylene oxide adducts;
polyglycidyl etherified products of aromatic compounds having two or more phenolic hydroxyl groups, such as resorcinol, hydroquinone, or catechol;
polyglycidyl etherified products of aromatic compounds having two or more alcoholic hydroxyl groups, such as phenyldimethanol, phenyldiethanol, or phenyldibutanol;
polyglycidyl esters of polybasic acid aromatic compound having two or more carboxyl groups, such as phthalic acid, terephthalic acid, or trimellitic acid;
diepoxide compounds of divinylbenzene; and
glycidyl amine compounds such as N,N-diglycidylaniline and its derivatives.

In addition, a compound obtained by reacting an aromatic epoxy compound having two or more glycidyl ether groups with a main chain skeleton containing a rubber component and containing a group capable of forming a covalent bond by reacting with an epoxy group can also be mentioned.

As aromatic epoxy compounds, commercial products can be used, and examples thereof include: Denacol EX-141, EX-142, EX-145, EX-146, Denacol EX-147, Denacol EX-201, Denacol EX-203, Denacol EX-711, Denacol EX-721, EX-731, Oncoat EX-1020, Oncoat EX-1030, Oncoat EX-1040, Oncoat EX-1050, Oncoat EX-1051, Oncoat EX-1010, Oncoat EX-1011, and Oncoat 1012 (manufactured by Nagase ChemteX Corporation); OGSOL PG-100, OGSOL EG-200, OGSOL EG-210, and OGSOL EG-250 (manufactured by Osaka Gas Chemicals Co., Ltd.); HP4032, HP4032D, and HP4700 (manufactured by DIC Corporation); ESN-475V (manufactured by Toto Kasei Co., Ltd.); YX8800 (manufactured by Mitsubishi Chemical Corporation); Marproof G-0105SA and Marproof G-0130SP (manufactured by NOF Corporation); ADEKA Resin EP-4000, ADEKA Resin EP-4005, ADEKA Resin EP-4100, ADEKA Resin EP-4901, EP-3950S, EP-3950L, EP-3980S, ADEKA Glycerol ED-501, ED-509S, and ED-529 (manufactured by ADEKA Corporation); and TECHMORE VG-3101L (manufactured by Printech Co., Ltd.).

The molecular weight of the epoxy group-containing compound is not particularly limited, but is preferably 74 to 2,000, more preferably 74 to 1,500, and particularly preferably 74 to 1,000.

Glycidol has a molecular weight of 74.

The reaction for obtaining the reaction product is preferably a reaction of a phenolic hydroxy group with an epoxy group. By the reaction, the epoxy group is ring-opened to produce a hydroxy group other than the phenolic hydroxy group.

The use mass ratio (F:E) of the compound (F) having at least one of a flavone structure and a flavanone structure to the epoxy group-containing compound (E) when synthesizing the reaction product is preferably 10:1 to 1:5, and more preferably 5:1 to 1:3.

The reaction for obtaining the reaction product may be performed, for example, in the presence of a catalyst. The catalyst is, for example, a quaternary phosphonium salt such as tetrabutylphosphonium bromide or ethyltriphenylphosphonium bromide, or a quaternary ammonium salt such as benzyltriethylammonium chloride. As the amount of the catalyst used, an appropriate amount can be selected from the range of 0.1 to 10 mass% relative to the total mass of the polymer raw material used in the reaction. As the temperature and the time for the polymerization reaction, for example, optimum conditions can be selected from the ranges of 80 to 160°C and 2 to 50 hours.

An example of the reaction product is shown below.

One example below is the reaction product of quercetin and glycidol.

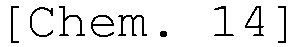

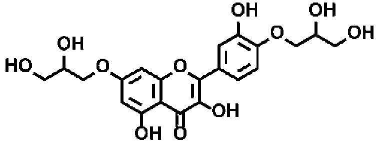

One example below is the reaction product of rutin and glycidol.

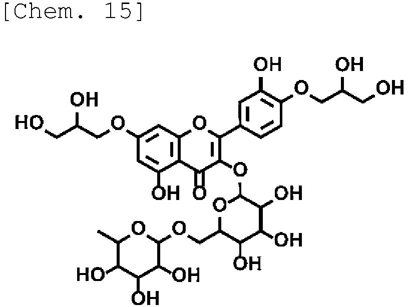

The molecular weight of the first component is not particularly limited.

From the viewpoint of the solubility in water, the weight average molecular weight of the first component is preferably small.

The weight average molecular weight of the first component is, for example, 300 to 100,000, preferably 300 to 50,000, more preferably 300 to 10,000, and particularly preferably 300 to 5,000.

The content of the first component in the film constituent components of the resist underlayer film-forming composition is not particularly limited, and is preferably 25 mass% to 99 mass%, more preferably 50 mass% to 90 mass%, and particularly preferably 60 mass% to 80 mass% relative to the film constituent components.

It should be noted that the film constituent components refer to the components other than the solvent in the resist underlayer film-forming composition.

### <Second Component>

The second component is used for improving the coatability of the resist underlayer film-forming composition.

The second component is a water-soluble polymer.

The second component is a compound different from the first component.

The water-soluble polymer is a polymer compound that dissolves in an amount of 1 g or more in 100 g of water at 25°C, preferably a polymer compound that dissolves in an amount of 5 g or more in 100 g of water at 25°C, and more preferably a polymer compound that dissolves in an amount of 10 g or more in 100 g of water at 25°C.

The water-soluble polymer is not particularly limited, and examples thereof include polyvinyl alcohol, water-soluble cellulose, polyethylene glycol (PEG), polyethylene oxide (PEO), polyvinylpyrrolidone, polyacrylic acid, polystyrenesulfonic acid, and polyvinyl acetamide.

The polyvinyl alcohol is a polymer prepared by hydrolyzing polyvinyl acetate to change an acetyl group in the polyvinyl acetate molecule to a hydroxyl group. A value obtained by expressing the proportion of the hydroxyl group in mol% is referred to as a saponification degree. Known polyvinyl alcohols have various properties depending on their saponification degrees. For example, polyvinyl acetate (saponification degree: 0 mol%) is generally water-insoluble, and polyvinyl alcohol having a saponification degree of 100 mol% is known as water-soluble. In the case of polyvinyl alcohol having a saponification degree of 60 mol% or less among polyvinyl alcohols, the solubility in water deteriorates. In the case of polyvinyl alcohol having a saponification degree of 30 mol% or less, the polyvinyl alcohol is not substantially dissolved. Conversely, when the saponification degree is too high, the solubility is low, and polyvinyl alcohol having a saponification degree of 85 to 90 mol% has the highest solubility. In the present invention, polyvinyl alcohol having a saponification degree of 70 mol% or more is preferably used. In general, the higher the saponification degree, the better the developer resistance. Thus, polyvinyl alcohol having a saponification degree of 75 mol% or more is preferably used. However, conversely, when the saponification degree is too high, the storage stability of the composition (generation of insoluble foreign matters) tends to deteriorate. Thus, the saponification degree of polyvinyl alcohol is preferably 99 mol% or less, and more preferably 98 mol% or less.

The polymerization degree of polyvinyl alcohol is ordinarily represented by a viscosity of a 4 mass% aqueous solution (at 20°C), and the viscosity is generally about 1 to 80 cps (mPa·s). Among the polyvinyl alcohols, the polyvinyl alcohol used in the present invention preferably has a viscosity of 1 cps or more, and more preferably has a viscosity of 2 cps or more. The upper limit of the viscosity is preferably 70 cps, and the upper limit of the viscosity is more preferably 65 cps, 50 cps, 40 cps, 30 cps, 20 cps, 10 cps, 8 cps, or 5 cps. The viscosity range is, for example, 1 to 20 cps, 2 to 10 cps, or 3 to 8 cps.

The polyvinyl alcohol may be modified by substituting some of its hydroxyl groups with an alkyl ether group, an alkyloxymethyl group, an acetyl acetate group, or the like.

The water-soluble cellulose is not particularly limited, and examples thereof include alkylcelluloses such as methylcellulose and ethylcellulose; hydroxyalkylcelluloses such as hydroxyethylcellulose and hydroxypropylcellulose; and hydroxyalkylalkylcelluloses such as hydroxyethylmethylcellulose and hydroxypropylmethylcellulose.

Among these water-soluble celluloses, hydroxypropylcellulose is more preferable.

As the hydroxypropylcellulose, various products having different viscosities are commercially available from various companies, and any of them can be used in the present invention. The viscosity of a 2 mass% aqueous solution of hydroxypropylcellulose (at 20°C) is not particularly limited, and can be appropriately selected depending on the purpose. The viscosity is preferably 2.0 mPa·s (centipoise, cps) or more and 4,000 mPa·s (centipoise, cps) or less.

Further, the viscosity of hydroxypropylcellulose is considered to depend on the weight average molecular weight, the degree of substitution, and the molecular weight of hydroxypropylcellulose.

The weight average molecular weight of hydroxypropylcellulose is not particularly limited, and can be appropriately selected depending on the purpose. The weight average molecular weight is preferably 15,000 or more and 400,000 or less. The weight average molecular weight can be measured using, for example, gel permeation chromatography (GPC).

A commercially available product of hydroxypropylcellulose is not particularly limited, and can be appropriately selected depending on the purpose. Examples of the commercially available product include the following commercially available products.
· HPC-SSL having a molecular weight of 15,000 or more and 30,000 or less and a viscosity of 2.0 mPa·s or more and 2.9 mPa·s or less (manufactured by Nippon Soda Co., Ltd.)
· HPC-SL having a molecular weight of 30,000 or more and 50,000 or less and a viscosity of 3.0 mPa·s or more and 5.9 mPa·s or less (manufactured by Nippon Soda Co., Ltd.) · HPC-L having a molecular weight of 55,000 or more and 70,000 or less and a viscosity of 6.0 mPa·s or more and 10.0 mPa·s or less (manufactured by Nippon Soda Co., Ltd.)
· HPC-M having a molecular weight of 110,000 or more and 150,000 or less and a viscosity of 150 mPa·s or more and 400 mPa·s or less (manufactured by Nippon Soda Co., Ltd.)
· HPC-H having a molecular weight of 250,000 or more and 400,000 or less and a viscosity of 1,000 mPa·s or more and 4,000 mPa·s or less (manufactured by Nippon Soda Co., Ltd.)

Among these commercially available products, HPC-SSL having a molecular weight of 15,000 or more and 30,000 or less and a viscosity of 2.0 mPa·s or more and 2.9 mPa·s or less is preferable.

In the commercially available products described above, the molecular weight is measured using gel permeation chromatography (GPC), and the viscosity is measured using a 2 mass% aqueous solution (at 20°C).

Examples of the polyvinylpyrrolidone include homopolymers of vinylpyrrolidone such as N-vinyl-2-pyrrolidone and N-vinyl-4-pyrrolidone, and copolymers of vinylpyrrolidone with vinyl acetate, α-olefin, styrene, and the like. The polyvinylpyrrolidone may be a three-dimensional crosslinked product.

As the polyvinylpyrrolidone, one having a K value of 60 or more in the Fickencher formula is preferably used, and in particular, one having a grade of K-60 to K-120 is preferable, and one having a number average molecular weight of 30,000 or more and 280,000 or less is preferable.

Examples of the polystyrenesulfonic acid include compounds in which a sulfonic acid group is substituted for a benzene ring of polystyrene, such as poly(3-styrene sulfonic acid), poly(4-styrene sulfonic acid), and poly(3,5-styrene sulfonic acid). The number of sulfonic acid group substitutions in the benzene ring is preferably 1 or more and 5 or less, and more preferably 1. The substitution position of the sulfonic acid group may be any of an ortho position (1 position or 5 position), a meta position (2 position or 4 position), and a para position (3 position). Among them, the meta position (2 or 4) is preferable. The repeating units constituting the polystyrenesulfonic acid may be one type or two or more types. When there are two or more types of repeating units constituting polystyrenesulfonic acid, the polystyrenesulfonic acid may be composed of a plurality of repeating units having different numbers of sulfonic acid group substitutions and different substitution positions. Furthermore, the polystyrenesulfonic acid may be configured to include a repeating unit (that is, a unit derived from styrene) in which a sulfonic acid group is not substituted. However, in this case, the polystyrenesulfonic acid is not constituted only by units derived from styrene.

The content of the second component (water-soluble polymer) in the resist underlayer film-forming composition is not particularly limited.

Addition of a small amount of the second component to the resist underlayer film-forming composition enables the coatability of the resist underlayer film-forming composition to be improved.

Accordingly, a mass ratio (first component:second component) between the first component and the second component in the resist underlayer film-forming composition is preferably 99:1 to 50:50, more preferably 99:1 to 75:25, and particularly preferably 99:1 to 90:10.

### <Crosslinking Agent>

The resist underlayer film-forming composition preferably includes a crosslinking agent.

The crosslinking agent included as an optional component in the resist underlayer film-forming composition has, for example, a functional group that singly reacts.

Examples of the crosslinking agent include hexamethoxymethylmelamine, tetramethoxymethylbenzoguanamine, 1,3,4,6-tetrakis(methoxymethyl)glycoluril (tetramethoxymethyl glycoluril) (POWDERLINK [registered trademark] 1174), 1,3,4,6-tetrakis(butoxymethyl)glycoluril, 1,3,4,6-tetrakis(hydroxymethyl)glycoluril, 1,3-bis(hydroxymethyl)urea, 1,1,3,3-tetrakis(butoxymethyl)urea, and 1,1,3,3-tetrakis(methoxymethyl)urea.

The crosslinking agent may be a nitrogen-containing compound described in WO 2017/187969 A and having 2 to 6 substituents represented by Formula (1d) described below that bond to a nitrogen atom in one molecule. 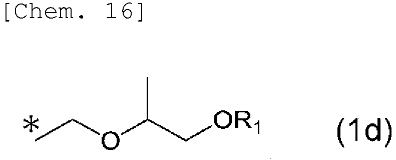 (In Formula (1d), R₁ represents a methyl group or an ethyl group. * represents a bond to a nitrogen atom.)

The nitrogen-containing compound having 2 to 6 substituents represented by Formula (1d) described above in one molecule may be a glycoluril derivative represented by Formula (1E) described below.

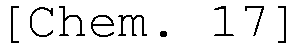

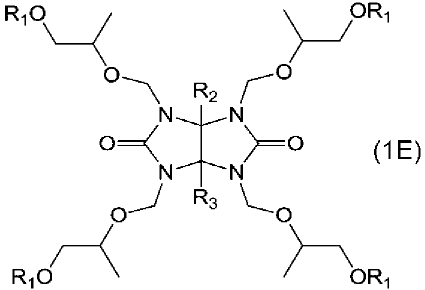

(In Formula (1E), four R₁'s each independently represent a methyl group or an ethyl group, and R₂ and R₃ each independently represent a hydrogen atom, an alkyl group having 1 to 4 carbon atoms, or a phenyl group.)

Examples of the glycoluril derivative represented by Formula (1E) described above include compounds represented by Formulae (1E-1) to (1E-6) described below.

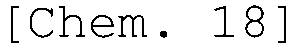

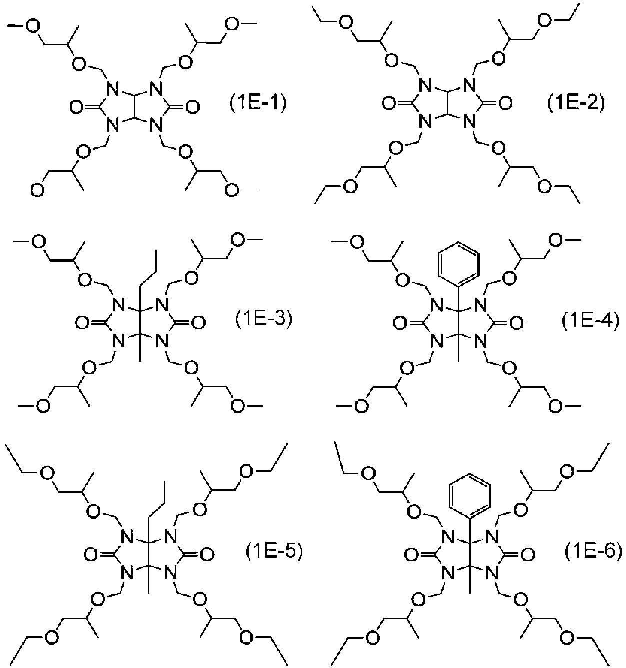

The nitrogen-containing compound having 2 to 6 substituents represented by Formula (1d) described above in one molecule is obtained by reacting a nitrogen-containing compound having 2 to 6 substituents represented by Formula (2d) described below that bond to a nitrogen atom in one molecule with at least one compound represented by Formula (3d) described below.

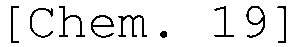

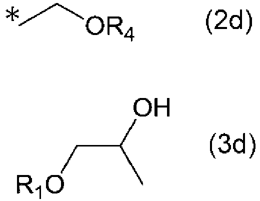

(In Formulae (2d) and (3d), R₁ represents a methyl group or an ethyl group, and R₄ represents an alkyl group having 1 to 4 carbon atoms. * represents a bond to a nitrogen atom.)

The glycoluril derivative represented by Formula (1E) described above is obtained by reacting a glycoluril derivative represented by Formula (2E) described below with at least one compound represented by Formula (3d) described above.

The nitrogen-containing compound having 2 to 6 substituents represented by Formula (2d) described above in one molecule is, for example, a glycoluril derivative represented by Formula (2E) described below.

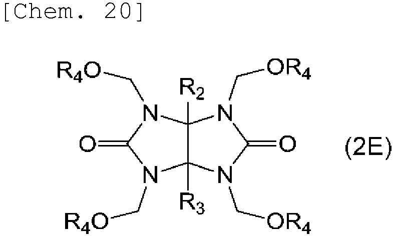

(In Formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.)

Examples of the glycoluril derivative represented by Formula (2E) described above include compounds represented by Formulae (2E-1) to (2E-4) described below. Examples of the compound represented by Formula (3d) described above include compounds represented by Formulae (3d-1) and (3d-2) described below.

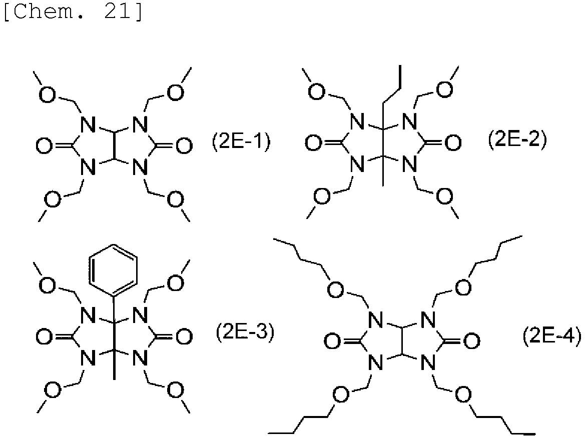

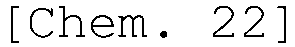

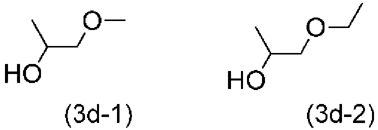

For the content related to the nitrogen-containing compound having 2 to 6 substituents represented by Formula (1d) that bond to a nitrogen atom in one molecule, the entire disclosure of WO 2017/187969 is incorporated in the present application by reference.

The crosslinking agent may be a crosslinkable compound represented by Formula (G-1) or (G-2) described below and described in WO 2014/208542 A.

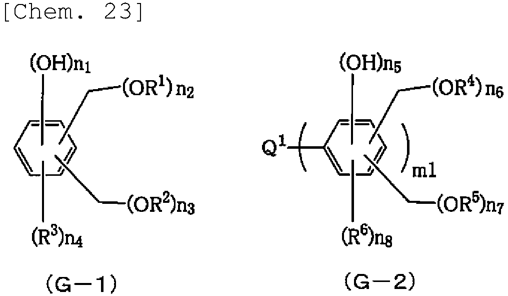

(In the formula, Q¹ represents a single bond or an m1-valent organic group, R¹ and R⁴ each represent an alkyl group having 2 to 10 carbon atoms or an alkyl group having 2 to 10 carbon atoms and having an alkoxy group having 1 to 10 carbon atoms, R² and R⁵ each represent a hydrogen atom or a methyl group, and R³ and R⁶ each represent an alkyl group having 1 to 10 carbon atoms or an aryl group having 6 to 40 carbon atoms.

n1 represents an integer that satisfies 1 ≤ n1 ≤ 3, n2 represents an integer that satisfies 2 ≤ n2 ≤ 5, n3 represents an integer that satisfies 0 ≤ n3 ≤ 3, n4 represents an integer that satisfies 0 ≤ n4 ≤ 3, and n1, n2, n3, and n4 satisfy 3 ≤ (n1 + n2 + n3 + n4) ≤ 6.

n5 represents an integer that satisfies 1 ≤ n5 ≤ 3, n6 represents an integer that satisfies 1 ≤ n6 ≤ 4, n7 represents an integer that satisfies 0 ≤ n7 ≤ 3, n8 represents an integer that satisfies 0 ≤ n8 ≤ 3, and n5, n6, n7, and n8 satisfy 2 ≤ (n5 + n6 + n7 + n8) ≤ 5.

m1 represents an integer of 2 to 10.)

The crosslinkable compound represented by Formula (G-1) or (G-2) may be obtained by a reaction of a compound represented by Formula (G-3) or (G-4) described below with a hydroxyl group-containing ether compound or an alcohol having 2 to 10 carbon atoms.

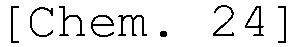

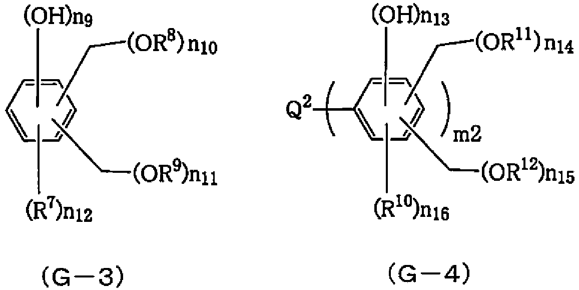

(In the formula, Q² represents a single bond or an m2-valent organic group. R⁸, R⁹, R¹¹, and R¹² each represent a hydrogen atom or a methyl group, and R⁷ and R¹⁰ each represent an alkyl group having 1 to 10 carbon atoms or an aryl group having 6 to 40 carbon atoms.

n9 represents an integer that satisfies 1 ≤ n9 ≤ 3, n10 represents an integer that satisfies 2 ≤ n10 ≤ 5, n11 represents an integer that satisfies 0 ≤ n11 ≤ 3, n12 represents an integer that satisfies 0 ≤ n12 ≤ 3, and n9, n10, n11, and n12 satisfy 3 ≤ (n9 + n10 + n11 + n12) ≤ 6.

n13 represents an integer that satisfies 1 ≤ n13 ≤ 3, n14 represents an integer that satisfies 1 ≤ n14 ≤ 4, n15 represents an integer that satisfies 0 ≤ n15 ≤ 3, n16 represents an integer that satisfies 0 ≤ n16 ≤ 3, and n13, n14, n15, and n16 satisfy 2 ≤ (n13 + n14 + n15 + n16) ≤ 5.

m2 represents an integer of 2 to 10.)

The compounds represented by Formulae (G-1) and (G-2) can be exemplified below.

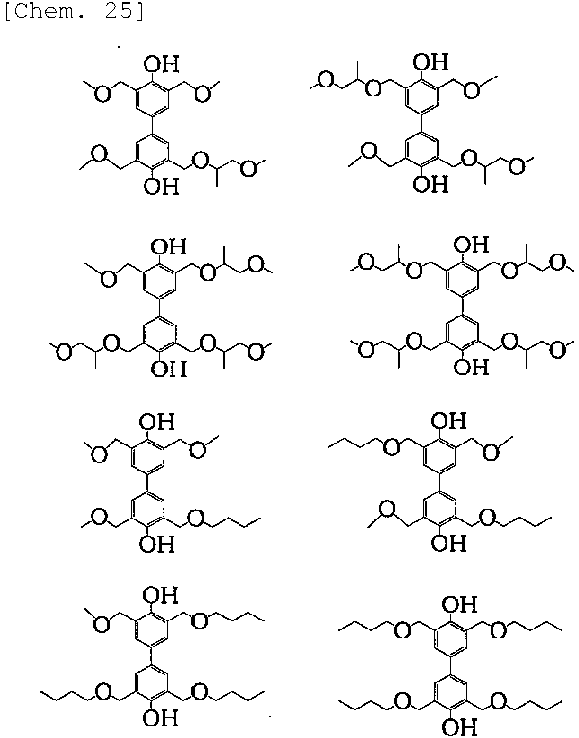

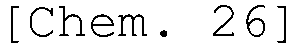

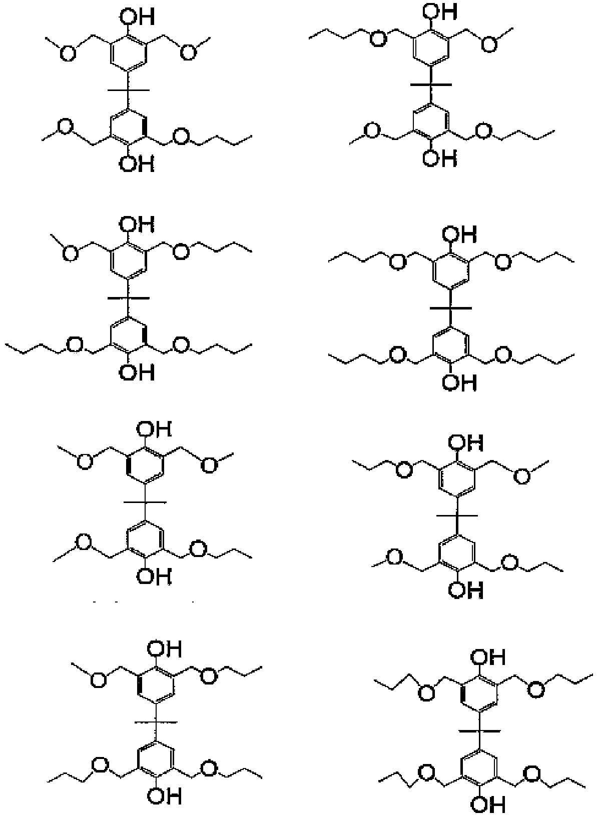

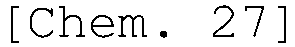

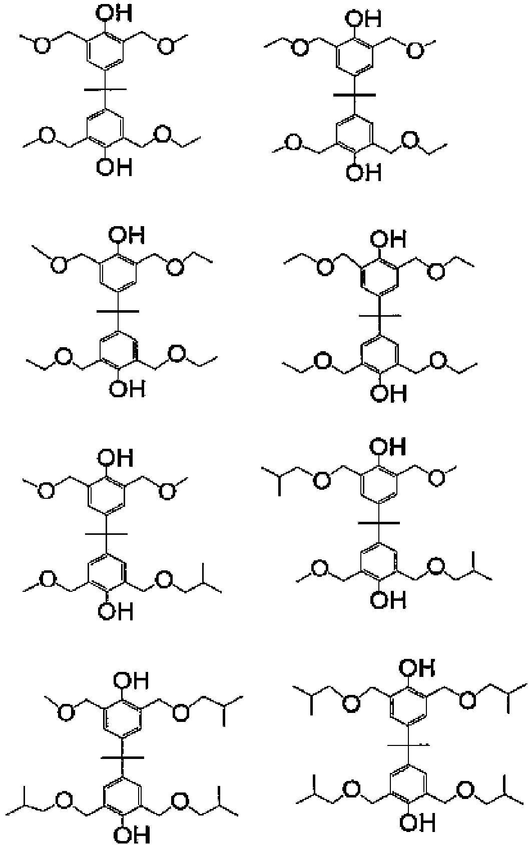

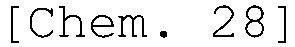

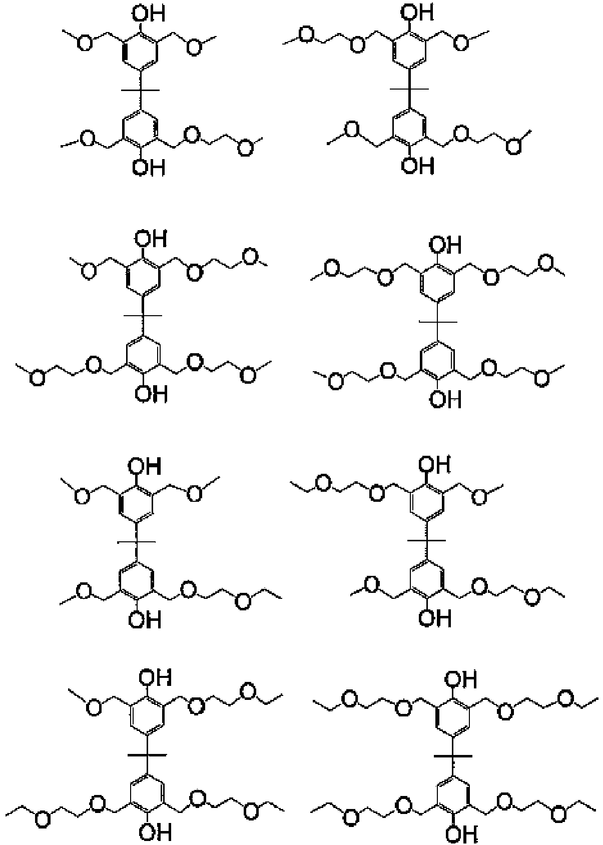

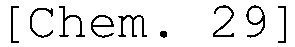

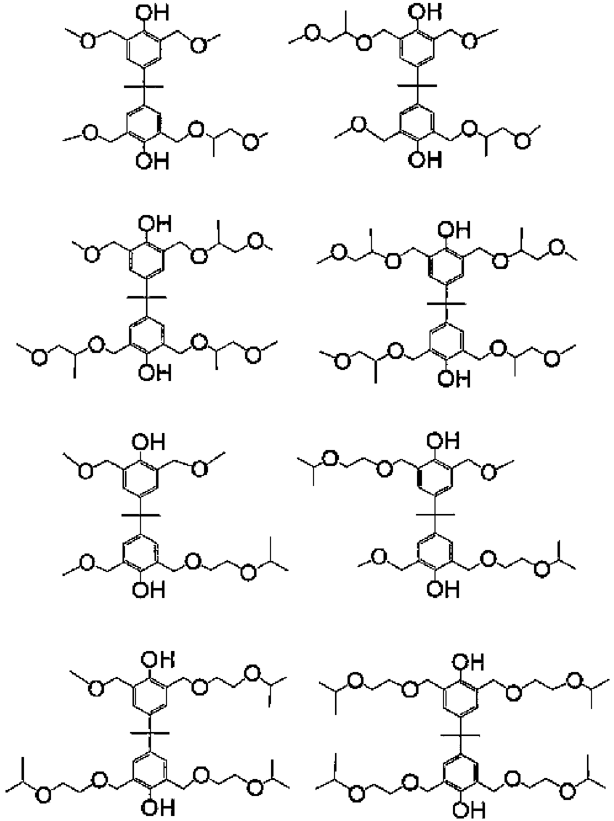

The compounds represented by Formulae (G-3) and (G-4) can be exemplified below.

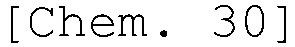

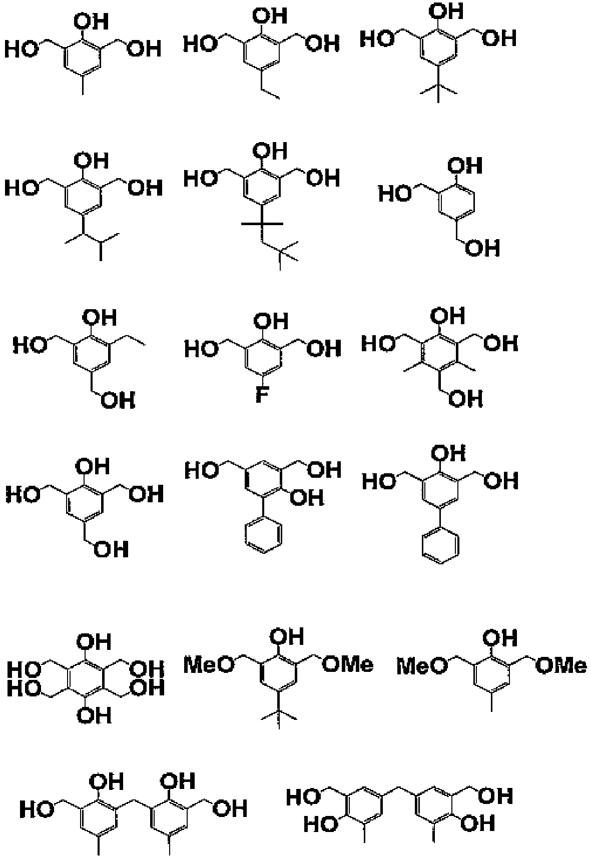

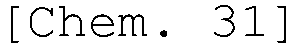

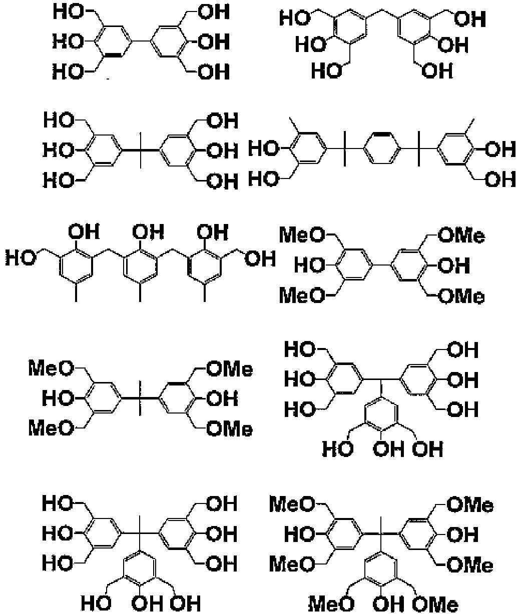

In the formulae, Me represents a methyl group.

The entire disclosure of WO 2014/208542 is incorporated in the present application by reference.

When the crosslinking agent is used, the content ratio of the crosslinking agent in the resist underlayer film-forming composition is, for example, 1 mass% to 50 mass%, preferably 5 mass% to 40 mass%, relative to the total of the first component and the second component.

When the crosslinking agent is used, the content ratio of the crosslinking agent in the resist underlayer film-forming composition is, for example, 1 mass% to 50 mass%, preferably 5 mass% to 40 mass%, relative to the total of the first component.

### <Curing Catalyst>

As the curing catalyst included as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one type of curing catalyst can be used, or two or more types thereof can be used in combination.

In the case of using the curing catalyst, the content ratio of the curing catalyst is, for example, 0.1 mass% to 50 mass%, and preferably 1 mass% to 30 mass% with respect to the crosslinking agent.

### <Solvent>

The resist underlayer film-forming composition contains a solvent.

The solvent contains water.

The solvent may contain an organic solvent in addition to water.

The solvent preferably contains water in an amount of 50 mass% or more, more preferably in an amount of 70 mass% or more, still more preferably in an amount of 80 mass% or more, and particularly preferably in an amount of 90 mass% or more, relative to the solvent.

As the organic solvent, an organic solvent generally used for a chemical for a semiconductor lithography process is preferable. Specific examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxy cyclopentane, anisole, γ-butyrolactone, N-methylpyrrolidone, N,N-dimethylformamide, and N,N-dimethylacetamide. One of these solvents can be used alone, or two or more of these solvents can be used in combination.

Among these solvents, propylene glycol monomethyl ether, propylene glycol monomethyl ether acetate, ethyl lactate, butyl lactate, and cyclohexanone are preferable. In particular, propylene glycol monomethyl ether and propylene glycol monomethyl ether acetate are preferable.

### <Other Components>

To the resist underlayer film-forming composition, a surfactant can be further added in order to further improve the coatability against surface unevenness without generating a pinhole, a striation, and the like.

Examples of surfactants include: linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl allyl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonion-based surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by Asahi Glass Co., Ltd., trade names); and organosiloxane polymer KP341 (manufactured by Shin-Etsu Chemical Co., Ltd.).

The amount of the surfactant blended is not particularly limited, and is usually 2.0 mass% or less, and preferably 1.0 mass% or less with respect to the total solid content of the resist underlayer film-forming composition.

These surfactants may be added alone, or two or more types thereof can also be added in combination.

The amount of the film-forming component included in the resist underlayer film-forming composition, that is, the component excluding the solvent is, for example, 0.01 mass% to 10 mass% of the resist underlayer film-forming composition.

The resist underlayer film-forming composition of the present invention is manufactured, for example, using a method for mixing the first component, the solvent, and the like by a known method. For being used as a resist underlayer film-forming composition, the composition is required to be in a uniform solution state. The manufactured composition is preferably manufactured by filtration with a filter or the like in order to remove a metal impurity, a foreign matter, and the like present in the composition.

One of the measures in evaluating whether the resist underlayer film-forming composition is in a uniform solution state is observation of the passability through a specific microfilter, and the resist underlayer film-forming composition according to the present invention preferably passes through microfilters having pore sizes of 0.1 µm, 0.05 µm, 0.03 µm, 0.02 µm, and 0.01 µm and exhibits a uniform solution state.

Examples of the material of the microfilter include fluorine-based resins such as polytetrafluoroethylene (PTFE) and tetrafluoroethylene-perfluoroalkyl vinyl ether copolymer (PFA), polyethylene (PE), ultra-high-molecular-weight polyethylene (UPE), polypropylene (PP), polysulfone (PSF), polyether sulfone (PES), and nylon, and the microfilter is preferably made of polytetrafluoroethylene (PTFE). Since the resist underlayer film-forming composition contains water as a solvent, the filter used for filtration of the resist underlayer film-forming composition is preferably a filter subjected to a hydrophilization treatment.

### (Resist Underlayer Film)

The resist underlayer film of the present invention is a cured product of the above-described resist underlayer film-forming composition.

The resist underlayer film can be manufactured, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using a semiconductor substrate having a surface on which an inorganic film is formed, the inorganic film is formed with, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film. The inorganic film may be a single layer or a multilayer including two or more layers. In the case of a multilayer, layers in the multilayer may be the same type of inorganic films or different types of inorganic films.

The thickness of the inorganic film is not particularly limited.

The resist underlayer film-forming composition of the present invention is applied onto such a semiconductor substrate with an appropriate application method using a spinner, a coater, or the like. Then, the composition is baked using heating means such as a hot plate to form a resist underlayer film. The baking conditions are appropriately selected from a baking temperature of 100°C to 400°C and a baking time of 0.3 minutes to 60 minutes. It is preferable that the baking temperature is 120°C to 350°C and the baking time is 0.5 minutes to 30 minutes, and it is more preferable that the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring a film thickness of the resist underlayer film in the present description is as follows.
· Name of measurement device: optical interference film thickness meter (product name: NanoSpec 6100, manufactured by Nanometrics Inc.)
· Arithmetic average of four points (for example, four points are measured at intervals of 1 cm in the X direction of the wafer.)

### (Semiconductor Processing Substrate)

The semiconductor processing substrate of the present invention includes a semiconductor substrate and the resist underlayer film of the present invention.

Examples of the semiconductor substrate include the above-described semiconductor substrates.

The resist underlayer film is disposed, for example, on the semiconductor substrate.

### (Method for Manufacturing Semiconductor Element and Method for Forming Pattern)

The method for manufacturing a semiconductor element of the present invention includes at least the following steps.
· a step of forming a resist underlayer film on a semiconductor substrate using the resist underlayer film-forming composition of the present invention
· a step of forming a resist film on the resist underlayer film

The method for forming a pattern of the present invention includes at least the following steps.
· a step of forming a resist underlayer film on a semiconductor substrate using the resist underlayer film-forming composition of the present invention;
· a step of forming a resist film on the resist underlayer film;
· a step of irradiating the resist film with light or an electron beam and then developing the resist film to obtain a resist pattern; and
· a step of etching the resist underlayer film using the resist pattern as a mask.

The resist film is usually formed on the resist underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, and 10 nm.

The resist film formed on the resist underlayer film with a known method (such as application and baking of a resist composition) is not particularly limited as long as the resist film responds to light or an electron beam (EB) used for irradiation. Both a negative photoresist and a positive photoresist can be used.

The light or electron beam is not particularly limited, and examples thereof include i-ray (365 nm), KrF excimer laser (248 nm), ArF excimer laser (193 nm), and EUV (extreme ultraviolet ray; 13.5 nm) and EB (electron beam).

In the present specification, a resist responding to EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used that include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition that contains a resin A including a repeating unit having an acid decomposable group in which a polar group is protected by a protecting group to be removed by the action of an acid, and that contains a compound represented by general Formula (21) described below.

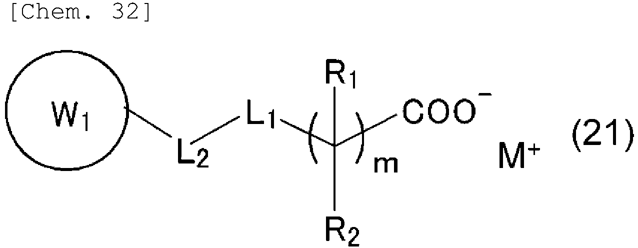

In general Formula (21), m represents an integer of 1 to 6.

R₁ and R₂ each independently represent a fluorine atom or a perfluoroalkyl group,

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by Formula (31) described below and a second structural unit represented by Formula (32) described below and containing an acid-dissociable group, and that contains an acid generator.

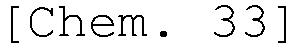

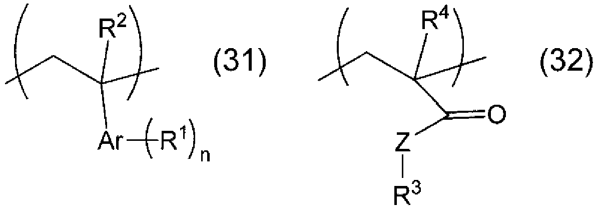

(In Formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In Formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.)

A resist composition that contains a resin (A1) including a structural unit having a cyclic carbonate structure, a structural unit represented by the following formula, and a structural unit having an acid-unstable group, and that contains an acid generator. 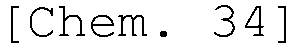 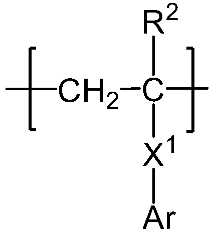 [In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxyl group.]

Examples of the resist film include the following.

A resist film including a base resin including a repeating unit represented by Formula (a1) described below and/or a repeating unit represented by Formula (a2) described below, and a repeating unit that generates an acid bonded to a polymer main chain by exposure.

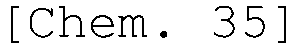

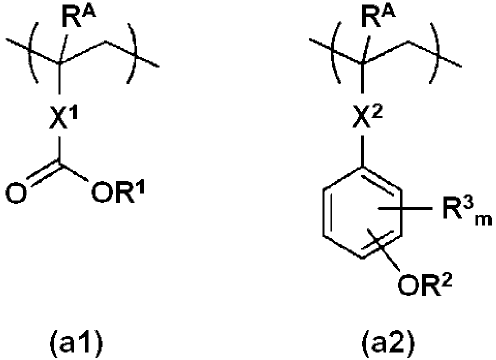

(In Formula (a1) and Formula (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.)

Examples of the resist material include the following.

A resist material containing a polymer having a repeating unit represented by Formula (b1) or Formula (b2) described below.

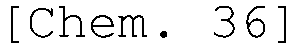

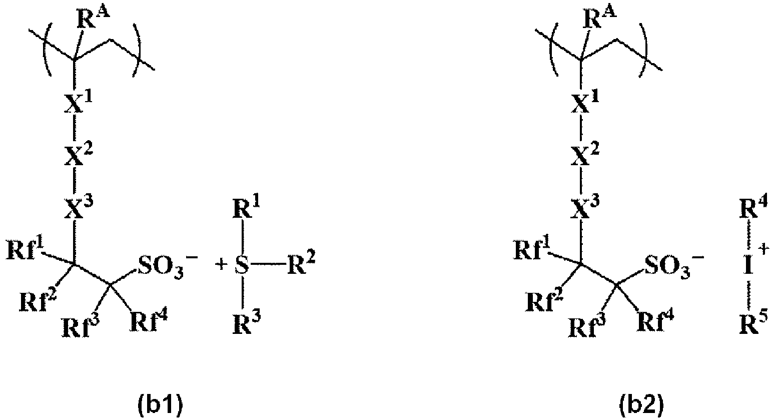

(In Formula (b1) and Formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group. R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group. R¹ and R² may be bonded to form a ring together with a sulfur atom to which R¹ and R² are bonded.)

A resist material containing a base resin including a polymer having a repeating unit represented by Formula (a) described below.

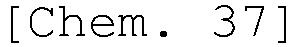

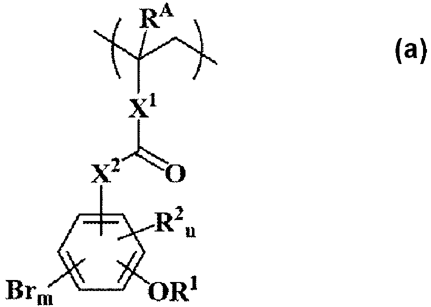

(In Formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, and u is an integer of 0 to 3, provided that m + u is an integer of 1 to 4.)

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by general Formula (f2-r-1) described below. 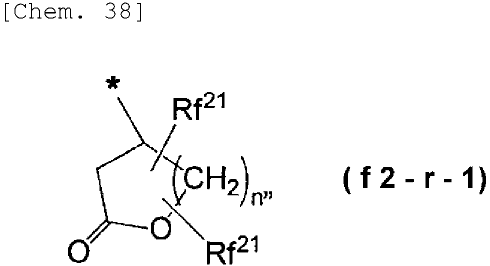
[In Formula (f2-r-1), Rf²¹'s are each independently a hydrogen atom, an alkyl group, an alkoxy group, a hydroxyl group, a hydroxyalkyl group, or a cyano group, n" is an integer of 0 to 2, and * is a bond.]

The constituent unit (f1) includes a constituent unit represented by general Formula (f1-1) described below or a constituent unit represented by general Formula (f1-2) described below. 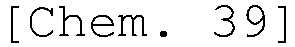 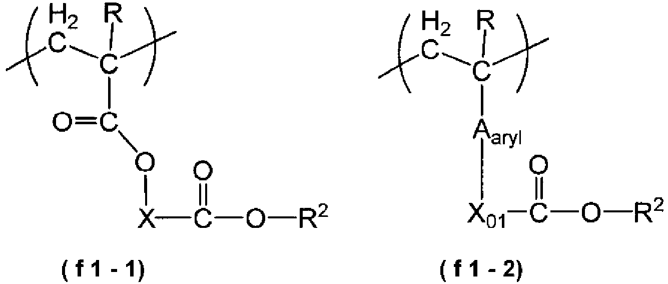 [In Formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic ring group which may have a substituent, X₀₁ is a single bond or a divalent linking group, and R²'s are each independently an organic group having a fluorine atom.]

Examples of a coating, a coating solution, and a coating composition include the following.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, in which R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (in the formula, 0 < x < 3), in which the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern.

The exposure amount and the irradiation energy of an electron beam are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Further, a surfactant or the like can also be added to these developers. It is also possible to use a method in which development is performed with an organic solvent such as butyl acetate in place of the alkaline developer and a part where the alkali dissolution rate of the photoresist is not improved is developed.

Subsequently, the resist underlayer film is etched using the formed resist pattern as a mask. The etching may be dry etching or wet etching, and dry etching is preferable.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Thereafter, the semiconductor substrate is subjected to a step of processing the semiconductor substrate by a known method (a dry etching method or the like), whereby a semiconductor device can be manufactured.

### Examples

Next, the contents of the present invention will be specifically described with reference to synthesis examples and examples, but the present invention is not limited thereto.

The weight average molecular weights of the polymers shown in Synthesis Examples 1 to 7 described below are measurement results by gel permeation chromatography (hereinafter abbreviated as GPC). For the measurement, a GPC apparatus manufactured by Tosoh Corporation was used, and measurement conditions and the like were as follows.
· GPC column: Shodex GF-710HQ, Shodex GF-510HQ, Shodex GF-310HQ [registered trademark] (Showa Denko K.K.)
· Column temperature: 40°C
Flow rate: 0.6 ml/min
Solvent: N,N-dimethylformamide (DMF)
Standard sample: polystyrene (Tosoh Corporation)

### <Synthesis Example 1>

A reaction flask prepared by adding 24.24 g of propylene glycol monomethyl ether to 3.97 g of rutin hydrate (manufactured by Tokyo Chemical Industry Co., Ltd.), 2.00 g of glycidol, and 0.08 g of tetrabutylphosphonium bromide was heated and stirred at 105°C for 12 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 930. The obtained reaction product was dissolved in ultrapure water to be 10 mass% to obtain an aqueous solution of the reaction product.

### <Synthesis Example 2>

A reaction flask prepared by adding 23.72 g of propylene glycol monomethyl ether to 4.24 g of rutin hydrate (manufactured by Tokyo Chemical Industry Co., Ltd.), 1.60 g of glycidol, and 0.08 g of tetrabutylphosphonium bromide was heated and stirred at 105°C for 12 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 840. The obtained reaction product was dissolved in ultrapure water to be 10 mass% to obtain an aqueous solution of the reaction product.

### <Synthesis Example 3>

A reaction flask prepared by adding 24.29 g of propylene glycol monomethyl ether to 4.77 g of rutin hydrate (manufactured by Tokyo Chemical Industry Co., Ltd.), 1.20 g of glycidol, and 0.10 g of tetrabutylphosphonium bromide was heated and stirred at 105°C for 12 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 750. The obtained reaction product was dissolved in ultrapure water to be 10 mass% to obtain an aqueous solution of the reaction product.

### <Synthesis Example 4>

A reaction flask prepared by adding 25.49 g of propylene glycol monomethyl ether to 2.75 g of quercetin hydrate (manufactured by Tokyo Chemical Industry Co., Ltd.), 3.50 g of glycidol, and 0.11 g of tetrabutylphosphonium bromide was heated and stirred at 105°C for 14 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 550. The obtained reaction product was dissolved in ultrapure water to be 10 mass% to obtain an aqueous solution of the reaction product.

### <Synthesis Example 5>

A reaction flask prepared by adding 22.84 g of propylene glycol monomethyl ether to 4.36 of α-glycosylrutin, 1.30 g of glycidol, and 0.04 g of tetrabutylphosphonium bromide was heated and stirred at 105°C for 16 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 760. The obtained reaction product was dissolved in ultrapure water to be 10 mass% to obtain an aqueous solution of the reaction product.

### <Synthesis Example 6>

A reaction flask prepared by adding 24.36 g of propylene glycol monomethyl ether to 5.03 g of α-glycosylrutin, 1.00 g of glycidol, and 0.05 g of tetrabutylphosphonium bromide was heated and stirred at 105°C for 20 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 680. The obtained reaction product was dissolved in ultrapure water to be 10 mass% to obtain an aqueous solution of the reaction product.

### <Synthesis Example 7>

A reaction flask prepared by adding 35.61 g of propylene glycol monomethyl ether to 6.76 g of rutin hydrate (manufactured by Tokyo Chemical Industry Co., Ltd.), 2.00 g of Denacol EX-810 (manufactured by Nagase ChemteX Corporation), and 0.14 g of tetrabutylphosphonium bromide was heated and stirred at 105°C for 20 hours under a nitrogen atmosphere. Thereafter, the reaction product solution was added dropwise to a hexane solution, and the obtained precipitate was separated by filtration and dried at 40°C under vacuum. The obtained reaction product was subjected to GPC analysis, and the weight average molecular weight Mw measured in terms of polystyrene was 2,600. The obtained reaction product was dissolved in ultrapure water to be 10 mass% to obtain an aqueous solution of the reaction product.

### <Example 1>

To 4.93 g of the aqueous solution of the reaction product prepared in Synthesis Example 1 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 2>

To 4.93 g of the aqueous solution of the reaction product prepared in Synthesis Example 2 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 3>

To 4.93 g of the aqueous solution of the reaction product prepared in Synthesis Example 3 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 4>

To 4.93 g of the aqueous solution of the reaction product prepared in Synthesis Example 4 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 5>

To 4.93 g of the aqueous solution of the reaction product prepared in Synthesis Example 5 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 6>

To 4.93 g of the aqueous solution of the reaction product prepared in Synthesis Example 6 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 7>

To 4.93 g of the aqueous solution of the reaction product prepared in Synthesis Example 7 (solid content: 10 mass%), 0.12 g of tetramethoxymethyl glycoluril, 0.02 g of pyridinium p-toluenesulfonate, 0.02 g of polyvinyl alcohol (POVAL PXP-05, manufactured by JAPAN VAM & POVAL CO., LTD.), and 24.89 g of ultrapure water were added to prepare a solution. The solution was filtered using a hydrophilic PTFE syringe filter having a pore size of 0.02 µm to prepare a resist underlayer film-forming composition.

### <Example 8>

To 0.49 g of troxerutin, 0.12 g of tetramethoxymethyl glycoluril, 0.02 g of pyridinium p-phenol sulfonic acid, 0.02 g of polyvinyl alcohol (POVAL PXP-05, JAPAN VAM & POVAL CO., LTD.), and 29.34 g of ultrapure water were added to form a solution. The solution was filtered using a hydrophilic PTFE syringe filter having a pore size of 0.02 µm to prepare a resist underlayer film-forming composition.

### <Example 9>

To 0.49 g of α-glycosylrutin, 0.12 g of tetramethoxymethyl glycoluril, 0.02 g of pyridinium p-phenol sulfonic acid, 0.02 g of polyvinyl alcohol (POVAL PXP-05, JAPAN VAM & POVAL CO., LTD.), and 29.34 g of ultrapure water were added to form a solution. The solution was filtered using a hydrophilic PTFE syringe filter having a pore size of 0.02 µm to prepare a resist underlayer film-forming composition.

### [Resist Solvent Resistance Test]

Each of the resist underlayer film-forming compositions prepared in Examples 1 to 9 was applied (spin-coated) onto a silicon wafer with a spin coater. The silicon wafer after coating was heated on a hot plate at 205°C for 1 minute to form a film (underlayer) with a film thickness of 25 nm. Next, in order to confirm the solvent resistance of the underlayer film, the silicon wafer after formation of the underlayer film was immersed in a mixed solvent prepared by mixing propylene glycol monomethyl ether and propylene glycol monomethyl ether acetate at a mass ratio of 7:3 for 1 minute, spin-dried, and then baked at 100°C for 30 seconds. The film thickness of the protective film before and after immersion in the mixed solvent was measured with an optical interference film thickness meter (product name: NanoSpec 6100, manufactured by Nanometrics Inc.).

The solvent resistance was evaluated by calculating the film thickness reduction rate (%) of the underlayer film removed by immersion in the solvent according to the following calculation formula.$Film thickness reduction rate \left(%\right) = \left(\left(A - B\right)\div A\right) \times 100$
A: Film thickness before solvent immersion
B: Film thickness after solvent immersion

The results are shown in Table 1. When the film thickness reduction rate is about 1% or less, it can be said that the film has sufficient solvent resistance.

**[Table 1]**

| Example | Film thickness reduction rate |
|---|---|
| Example 1 | 0.0% |
| Example 2 | -0.2% |
| Example 3 | 0.0% |
| Example 4 | -0.1% |
| Example 5 | 0.0% |
| Example 6 | 0.0% |
| Example 7 | -0.2% |
| Example 8 | -0.4% |
| Example 9 | 0.0% |

From the above results, the films formed from the resist underlayer film-forming compositions of Examples 1 to 9 had a very small change in film thickness even after being immersed in the solvent. Accordingly, the films formed from the resist underlayer film-forming compositions of Examples 1 to 9 have sufficient solvent resistance to function as an underlayer film.

In Examples 2, 4, 7, and 8, the film thickness reduction rate is negative, but there is no particular problem.

### [Evaluation of Optical Parameters]

Each of the resist underlayer film-forming compositions prepared in Examples 1 to 9 was applied onto a silicon wafer with a spin coater. The silicon wafer after coating was heated on a hot plate at 205°C for 1 minute to form a resist underlayer film (film thickness: 30 nm). Then, for these resist underlayer films, an n value (refractive index) and a k value (attenuation coefficient or extinction coefficient) at a wavelength of 365 nm were measured using a spectroscopic ellipsometer (product name: VUV-VASE VU-302, manufactured by J.A.Woollam). The measurement results of the optical parameters are shown in Table 2.

**[Table 2]**

| Example | n/k @365 nm |
|---|---|
| Example 1 | 1.64/0.18 |
| Example 2 | 1.64/0.18 |
| Example 3 | 1.65/0.17 |
| Example 4 | 1.70/0.18 |
| Example 5 | 1.63/0.16 |
| Example 6 | 1.64/0.18 |
| Example 7 | 1.65/0.19 |
| Example 8 | 1.64/0.21 |
| Example 9 | 1.65/0.19 |

From the above results, the film formed from the resist underlayer film-forming composition of Examples 1 to 9 has an absorption at 365 nm and can be used as a resist lower layer film.

## Claims

1. A resist underlayer film-forming composition containing
a first component, a second component, and a solvent, wherein
the first component has an aromatic ring and at least one oxygen atom directly bonded to the aromatic ring by a single bond,
the second component is a water-soluble polymer,
a mass ratio between the first component and the second component (first component:second component) is 99:1 to 50:50,
the solvent contains water in an amount of 50 mass% or more based on the solvent, and
the resist underlayer film-forming composition contains a curing catalyst.

2. The resist underlayer film-forming composition according to claim 1, wherein the first component has an aromatic ring and at least two oxygen atoms directly bonded to the aromatic ring by a single bond.

3. The resist underlayer film-forming composition according to claim 1, wherein the first component has at least one of a flavone structure and a flavanone structure.

4. The resist underlayer film-forming composition according to claim 1, wherein the first component has a quercetin structure.

5. The resist underlayer film-forming composition according to claim 4, wherein the first component is at least one selected from
α-glucosylrutin,
troxerutin, and
a reaction product of at least one of quercetin and a quercetin glycoside with an epoxy group-containing compound.

6. The resist underlayer film-forming composition according to claim 5, wherein the epoxy group-containing compound is an aliphatic epoxy compound having at least one epoxy group.

7. The resist underlayer film-forming composition according to claim 1, wherein the water-soluble polymer is at least one selected from polyvinyl alcohol, polyvinylpyrrolidone, polystyrenesulfonic acid, and water-soluble cellulose.

8. The resist underlayer film-forming composition according to claim 1, further containing a crosslinking agent.

9. A resist underlayer film which is a cured product of the resist underlayer film-forming composition according to claim 1.

10. A semiconductor processing substrate comprising:
a semiconductor substrate; and
the resist underlayer film according to claim 9.

11. A method for manufacturing a semiconductor element, the method comprising:
a step of forming a resist underlayer film on a semiconductor substrate using the resist underlayer film-forming composition; and
a step of forming a resist film on the resist underlayer film,
wherein the resist underlayer film-forming composition contains a first component, a second component, and a solvent, wherein
the first component has an aromatic ring and at least one oxygen atom directly bonded to the aromatic ring by a single bond,
the second component is a water-soluble polymer,
a mass ratio between the first component and the second component (first component:second component) is 99:1 to 50:50,
the solvent contains water in an amount of 50 mass% or more based on the solvent, and
the resist underlayer film-forming composition contains a curing catalyst.

12. A method for forming a pattern comprising:
a step of forming a resist underlayer film on a semiconductor substrate using a resist underlayer film-forming composition;
a step of forming a resist film on the resist underlayer film;
a step of irradiating the resist film with light or an electron beam, and then developing the resist film to obtain a resist pattern; and
a step of etching the resist underlayer film using the resist pattern as a mask,
wherein the resist underlayer film-forming composition contains a first component, a second component, and a solvent, wherein
the first component has an aromatic ring and at least one oxygen atom directly bonded to the aromatic ring by a single bond,
the second component is a water-soluble polymer,
a mass ratio between the first component and the second component (first component:second component) is 99:1 to 50:50,
the solvent contains water in an amount of 50 mass% or more based on the solvent, and
the resist underlayer film-forming composition contains a curing catalyst.
